(19) Europäisches Patentamt
European Patent Office
Office européen des brevets

(11) **EP 4 737 932 A1**

(12) **EUROPEAN PATENT APPLICATION**

(43) Date of publication:
**06.05.2026 Bulletin 2026/19**

(21) Application number: **24210141.8**

(22) Date of filing: **31.10.2024**

(51) International Patent Classification (IPC):
***G01R 33/36*** (2006.01)

(52) Cooperative Patent Classification (CPC):
**G01R 33/3635; G01R 33/3415**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **WaveTronica B.V.**
**4191 NW  Geldermalsen (NL)**

(72) Inventors:
• **Voogt, Ingmar Jacob**
**4191NW Geldermalsen (NL)**
• **Gosselink, Wilhelmus Johannes Maria**
**4191NW Geldermalsen (NL)**

(74) Representative: **Laddé, Jurre Gerard**
**Patentbureau De Nederlanden B.V.**
**Groot Wezenland 27A**
**8011 JW Zwolle (NL)**

(54) **A SYSTEM FOR IMAGING A HUMAN BREAST USING MAGNETIC RESONANCE IMAGING**

(57)    This disclosure relates to a system for imaging a human breast using magnetic resonance imaging, MRI. The system comprises a first antenna system comprising one or more linear antennas. Each linear antenna out of the one or more linear antennas is tuned to a first frequency and is configured to send excitation signals having the first frequency into the human breast for exciting nuclei of a first type that are present in the human breast and/or is configured to receive nuclear magnetic resonance, NMR, relaxation signals from the nuclei of the first type in the human breast. The system also comprises a second antenna system comprising one or more loop antennas. Each loop antenna is tuned to a second frequency that is different from the first frequency, and is configured to send excitation signals having the second frequency into the human breast for exciting nuclei of a second type that are present in the human breast, the second type being different from the first type and/or is configured to receive NMR relaxation signals from the nuclei of the second type in the human breast.

Fig. 1

## Description

## FIELD OF THE INVENTION

This disclosure relates to a system for imaging a human breast using magnetic resonance imaging (MRI), in particular so such system that comprises a first antenna system for detecting a first type of nuclei and a second antenna system for detecting a second type of nuclei.

## BACKGROUND

MRI is a valuable technique for detection and analysis of compounds that are present in cancerous breast tissue.

US2009/0118611 A1 describes a unified heteronuclear coil system that includes a volume coil tuned to detect a first nuclei and a butterfly coil to detect a second nuclei. A disadvantage of the system is that its detection accuracy and detection sensitivity are quite limited.

## SUMMARY

One aspect of this disclosure relates to a system for imaging a human breast using magnetic resonance imaging, MRI. The system comprises a first antenna system comprising one or more linear antennas. Each linear antenna out of the one or more linear antennas is tuned to a first frequency and is configured to send excitation signals having the first frequency into the human breast for exciting nuclei of a first type that are present in the human breast and/or is configured to receive nuclear magnetic resonance, NMR, relaxation signals from the nuclei of the first type in the human breast. The system also comprises a second antenna system comprising one or more loop antennas. Each loop antenna is tuned to a second frequency that is different from the first frequency, and is configured to send excitation signals having the second frequency into the human breast for exciting nuclei of a second type that are present in the human breast, the second type being different from the first type and/or is configured to receive NMR relaxation signals from the nuclei of the second type in the human breast.

This system is advantageous in that it allows to detect both nuclei of the first type and nuclei of the second type in one scan session. The first antenna system can send and receive signals for detecting nuclei of the first type and the second antenna system can send and receive signals for detecting nuclei of the second type. Linear antennas are especially suitable for sending and receiving signals for detection of 1H nuclei. The system is further advantageous in that it is relatively easy to design a configuration of one or more linear antennas and one or more loop antennas in which the linear antennas and loop antennas are not, or only to a limited degree, electromagnetically coupled to each other. Typically, such configuration can be achieved by positioning each linear antenna at some minimum distance from any conductor of any loop antenna. This is often very well possible as linear antennas have an elongated shape, while loop antennas comprise respective conductor loops. Hence, it is typically possible to position a loop such that it at least partially surrounds a linear antenna, at least as viewed from one point of view.

Mutual coupling between antennas is an intricate phenomenon and is undesired for a variety of reasons. A first reason is that electromagnetic coupling between linear antenna and loop antenna typically introduces noise and therefore reduces the signal to noise ratios of the linear antenna as well as the loop antenna. A second reason is that such electromagnetic coupling may cause power transfer from a linear antenna to a loop antenna when the linear antenna is sending excitation signals, and may cause power transfer from a loop antenna to a linear antenna when the loop antenna is sending excitation signals. Such power transfer is undesired, not only because it may damage the loop antennas or signal processing hardware connected to the loop antenna and/or to the linear antenna, but also because it may increase the specific absorption rate (SAR) of the system which comes with a risk of damaging breast tissue and/or skin tissue. Preferably, any electromagnetic coupling between any of the one or more loop antennas and any of the one or more linear antennas is less than -10 dB, preferably less than -20 dB, more preferably less than -25 dB.

It would be more complex to design a system having a first second antenna system comprising one or more loop antennas tuned to the first frequency and a second antenna system comprising one or more loop antennas tuned to the second frequency wherein the loop antennas of the first coil system would not be coupled, or coupled only to a limited extent, to loop antennas of the second coil system. This is especially true if the first coil system would comprise more than one loop antenna and the second loop antenna would comprise more than one loop antenna.

A further advantage of the system disclosed herein is that the linear antennas out of the first antenna system don't need to be actively tunable and that the loop antennas out of the second antenna system don't need to be actively tunable. Each antenna in the system, be it a loop antenna out of the one or more loop antennas or a linear antenna out of the one or more linear antennas, may be a single-tuned, non-tunable antenna, which provides for a relatively simple yet efficient and effective design. As referred to herein, a single-tuned antenna may be understood to refer to an antenna circuit that is resonant to one and only one frequency.

As known in the art, which frequency is suitable for exciting nuclei of the first type and which frequency is suitable for exciting nuclei of the second type is given by the Larmor equation:

$$\omega_0 = \gamma B_0$$

, wherein $\omega_0$ is the Larmor frequency, $\gamma$ is the gyromagnetic ratio of the type of nuclei in question, and $B_0$ is the external magnetic field. The first resp. second frequency is equal to the Larmor frequency for the first resp. second type of nuclei. The $B_0$ is the main, static magnetic field that polarizes the spins of nuclei that are present in the human breast. The excitation signals are typically radio frequency (RF) signals. The excitation signals are applied perpendicular to the $B_0$ field to perturb the magnetization of the nuclei in some manner.

Thus, the higher the $B_0$ field, the higher the Larmor frequency. For example, if the $B_0$ field is 7T, then the Larmor frequency of 1H is so high (and the associated wavelength so short) that 1H nuclei can very well be excited using linear antennas and that the NMR relaxation signals from 1H nuclei can very well be picked up by linear antennas. One aspect of this disclosure relates to an MRI scanner that is configured to generate a $B_0$ field of at least 6T, preferably 7T, and that comprises any of the systems for imaging a human breast as described herein.

As referred to herein, a linear antenna may be a monopole antenna, dipole antenna, J-pole antenna, or any other type of linear antenna. Any linear antenna referred to herein may be a meander-line antenna that comprises a meandering conductor.

In an embodiment, the one or more linear antennas of the first antenna system are one or more dipole antennas, preferably one or more meander-line dipole antennas.

In an embodiment, the one or more linear antennas comprise at least two linear antennas. Additionally or alternatively, the one or more loop antennas comprise at least two loop antennas.

Having multiple antennas for sending excitation signals for exciting nuclei of the same type is beneficial in that it allows to excite the nuclei of that type in quadrature, which allows to create a circularly polarized $B_1$ field, which greatly reduces wasted power relative to a linearly polarized $B_1$ field.

The fact that it is relatively easy to position linear antennas and loop antennas such that they are not electromagnetically coupled to each other is especially beneficial in case multiple antennas are used for scanning the first type of nuclei and multiple antennas are used for scanning the second type of nuclei. It would be very difficult to position that many antennas without undesired coupling between them if all antennas would be loop antennas, for example.

In a preferred embodiment, the one or more linear antennas comprise at least two linear antennas and the one or more loop antennas comprise at least two loop antennas.

In an embodiment, the one or more linear antennas comprise two and only two linear antennas and the one or more loop antennas comprise two and only two loop antennas.

In an embodiment, each linear antenna out of the one or more linear antennas is single-tuned. Additionally or alternatively, each loop antenna out of the one or more loop antennas is single-tuned. Preferably, each linear antenna out of the one or more linear antennas is single-tuned and each loop antenna out of the one or more loop antennas is single-tuned.

This embodiment allows for relatively simple antennas as they don't require a trap circuit, for example, to make them resonant to multiple, distinct frequencies. Such trap circuit would be undesired as it would be a source of noise and lower the signal to noise ratio. Further, such trap circuit is essentially a small resonant circuit that may pick up a local field having a near resonant frequency. Then, the trap circuit may significantly increase SAR and damage the breast tissue.

In an embodiment, each linear antenna out of the one or more linear antennas is single-tuned, while each loop antenna out of the one or more loop antennas is dual-tuned. In this embodiment, each loop antenna would comprise a trap circuit for causing the loop antenna in question to be dual-tuned.

In an embodiment, the system does not comprise a tuning circuit with a PIN diode for tuning, by means of electrical signaling provided to the tuning circuit, any loop antenna out of the one or more loop antennas.

In an embodiment, the system does not comprise a tuning circuit with a PIN diode for tuning, by means of electrical signaling provided to the tuning circuit, any antenna out of the one or more linear antennas or one or more loop antennas.

These embodiments are advantageous as they allow for antennas having a relatively high antenna sensitivity. As already indicated, an advantage of the system disclosed herein is that the system as a whole is dual-tuned in that each of the one or more linear antennas is tuned to the first frequency and in that each of the one or more loop antennas is tuned to the second frequency. Hence, the dual-tuned property of the system as a whole is not occasioned by tuning circuits with PIN diodes with which antennas can be actively tuned. A PIN diode is well known in the art and may be understood to refer to a diode with a relatively wide, undoped intrinsic semiconductor region between a p-type semiconductor and an n-type semiconductor region. The p-type and n-type regions are typically heavily doped because they are used for ohmic contacts. The high-frequency resistance of a PIN diode is inversely proportional to the DC bias current applied it. The DC current bias applied to the PIN diode may be understood as electrical signaling provided to the tuning circuit comprising the PIN diode in question. A disadvantage of PIN diodes is that they have a resistance, even when forward biased, and thus decrease the sensitivity of the antenna in question.

Especially if the nuclei of the second type are 31P nuclei, then each loop antenna out of the one or more loop antennas requires a relatively high sensitivity which may not be feasible if tuning circuits with PIN diodes are used for actively tuning the loop antennas.

It should be appreciated that in this embodiment, the system may still comprise PIN diodes that are configured to switch the first antenna system and/or second antenna system between transmission mode and reception mode.

In an embodiment, the first antenna system comprises a first antenna control system that is configured to cause at least one linear antenna, preferably all linear antennas, out of the one or more linear antennas to send excitation signals for exciting nuclei of the first type that are present in the human breast and to process the NMR relaxation signals from the nuclei of the first type as received by the at least one linear antenna, and the second antenna system comprises a second antenna control system that is configured to cause at least one loop antenna, preferably all loop antennas, out of the one or more loop antennas to send excitation signals for exciting nuclei of the second type that are present in the human breast and to process the NMR relaxation signals from the nuclei of the second type as received by the at least one loop antenna.

This embodiment is advantageous as it allows to send excitation signals with multiple antennas, and to receive NMR relaxation signal with multiple antennas, without having to increase the number of antennas. If only transmit-only and receive-only antennas would be used, then many antennas would be required if one desires to transmit excitation signals with multiple antennas and receive NMR relaxation signals with multiple antennas. Sending excitation signals with multiple antennas is beneficial as it allows for quadrature transmission which is power efficient. Receiving NMR relaxation signals with multiple antennas is beneficial as it allows to more accurately determine the position of the nuclei that are sending out the NMR relaxation signals.

In an embodiment, the nuclei of the first type are 1H nuclei. Linear antennas are suitable for detecting 1H nuclei.

The nuclei of the first type may alternatively be 2H nuclei or 14N nuclei or 19F nuclei or 31P nuclei or 13C nuclei or 23Na nuclei or 39K nuclei or 17O nuclei or 129Xe nuclei.

In an embodiment, the nuclei of the second type are 31P nuclei. The loop antennas are suitable for detecting 31P nuclei.

The nuclei of the second type may alternatively be 1H nuclei or 2H nuclei or 14N nuclei or 19F nuclei or 31P nuclei or 13C nuclei or 23Na nuclei or 39K nuclei or 17O nuclei or 129Xe nuclei.

In a preferred embodiment, the nuclei of the first type are 1H nuclei and the nuclei of the second type are 31P nuclei.

In an embodiment, the system comprises a volume for accommodating the human breast, wherein the one or more linear antennas and the one or more loop antennas are positioned around the volume.

This embodiment enables to easily ensure that the human breast is positioned correctly relative to the one or more linear antennas and relative to the one or more loop antennas.

The volume is preferably shaped as a human breast and/or would typically have a hemispheroidal shape, to ensure that the linear antennas and loop antennas are appropriately positioned around the human breast.

In an embodiment, each linear antenna out of the one or more linear antennas is bent around at least part the volume.

This embodiment allows for the respective fields of view of the linear antennas to appropriately cover the human breast that sits in the volume which aids to improve the signal to noise ratio as well as the transmit efficiency.

In an embodiment, each loop antenna comprises a conductor loop, wherein, for each conductor loop, at least part of the conductor loop is bent around the volume. Each conductor loop may lie on a hemispheroidal shape.

In an embodiment, each loop antenna comprises a conductor loop that comprises a first part and a second part, which first part and second part lie in respective different planes that make an angle with each other. Each conductor loop may thus be kinked there where the respective planes meet.

In an embodiment, the one or more loop antennas comprises a first loop antenna and a second loop antenna. In this embodiment, the first part of the conductor loop of the first loop antenna lies in a first plane and the second part of the conductor loop of the first loop antenna lies in a second plane. Additionally, the first part of the conductor loop of the second loop antenna lies in the first plane and the second part of the conductor loop of the second loop antenna lies in a fourth plane. The second plane and fourth plane preferably make an angle with each other.

In an embodiment each loop antenna comprises a conductor loop that is kinked at a plurality of positions along the conductor loop.

The kinks in each conductor loop are beneficial because they allow, on average, for a relatively large distance between two opposite parts of the conductor loop. In other words, the kinks allow to position a loop antenna's conductor loop around a linear antenna without the loop antenna and linear antenna being electromagnetically coupled too strongly.

In an embodiment, the one or more loop antennas comprises a or the first loop antenna and a or the second loop antenna, wherein the first loop antenna comprises a first conductor loop and the second loop antenna comprises the second conductor loop, wherein the first conductor loop and second conductor loop at least partially overlap each other.

This embodiment enables to prevent that an NMR relaxation signal passes between the two loop antennas which would mean that, in case the one or more loop antennas comprise two and only two loop antennas, the NMR relaxation signal would not be measured.

As referred to herein, two conductor loops overlapping may be understood as that there can be NMR relaxation signals originating from nuclei in the human breast which NMR relaxation signals are pass through the two conductor loops and are thus measured by the two loop antennas comprising the respective conductor loops.

In an embodiment, each linear antenna out of the one or more linear antennas comprises a meandering conductor.

Such meandering conductor advantageously allows to reduce the physical dimensions of the linear antenna. Smaller linear antennas are more easily positioned relative to loop antennas in such manner that they do not couple too strongly.

One aspect of this disclosure relates to a method for imaging a human breast using magnetic resonance imaging, MRI, with any of the systems disclosed herein. The method comprises, during a first time period, the first antenna system sending excitation signals having the first frequency to the human breast herewith exciting nuclei of the first type that are present in the human breast, and, during a second time period after the first time period, the first antenna system receiving NMR relaxation signals from the nuclei of the first type, and, during a third time period, the second antenna system sending excitation signals having the second frequency to the human breast herewith exciting nuclei of the second type that are present in the human breast, and, during a fourth time period after the third time period, the second antenna system receiving NMR relaxation signals from the nuclei of the second type.

The method may comprise a first antenna control system causing the first antenna system to send the excitation signals having the first frequence and the first antenna control system processing the NMR relaxation signals that are received by first antenna system. Further, the method may comprise a second antenna control system causing the second antenna system to send the excitation signals having the second frequency and the second antenna control system processing the NRM relaxation signals as received by the second antenna system.

In an embodiment of the method, the first time period, second time period, third time period and fourth time period are non-overlapping time periods. This may be understood as that the each time period does not overlap with any of the other time periods.

In an embodiment of the method, during the first and second time period, each loop antenna of the one or more loop antennas remains tuned to the second frequency, and during the third and fourth time period, each linear antenna of the one or more linear antennas remains tuned to the first frequency.

In this embodiment, performing the method does not require the system to comprise tuning circuits for actively tuning loop antennas or linear antennas.

One aspect of this disclosure relates to a computer-implemented method for imaging a human breast using magnetic resonance imaging, MRI, with any of the systems disclosed herein. The method comprises causing the first antenna system to, during a first time period, send excitation signals having the first frequency to the human breast herewith exciting nuclei of the first type that are present in the human breast, and causing the first antenna system to, during a second time period after the first time period, receive NMR relaxation signals from the nuclei of the first type, and to cause the second antenna system to, during a third time period, send excitation signals having the second frequency to the human breast herewith exciting nuclei of the second type that are present in the human breast, and to cause the second antenna system to, during a fourth time period after the third time period, receive NMR relaxation signals from the nuclei of the second type.

One aspect of this disclosure relates to a computer comprising a computer readable storage medium having computer readable program code embodied therewith, and a processor, preferably a microprocessor, coupled to the computer readable storage medium, wherein responsive to executing the computer readable program code, the processor is configured to perform any of the computer-implemented methods described herein.

One aspect of this disclosure relates to a computer program comprising instructions which, when the program is executed by a computer, cause the computer to carry out any of the computer-implemented methods described herein.

One aspect of this disclosure relates to a computer-readable data carrier having stored thereon any of the computer programs described herein.

The computer-readable data carrier may be hard disk, for example, or a signal.

One aspect of this disclosure relates to a computer readable storage medium having computer readable program code embodied therewith, and a processor, preferably a microprocessor, coupled to the computer readable storage medium, wherein responsive to executing the computer readable program code, the processor is configured to perform any of the computer-implemented methods described herein.

One aspect of this disclosure relates to a computer program or suite of computer programs comprising at least one software code portion or a computer program product storing at least one software code portion, the software code portion, when run on a computer system, being configured for executing any of the computer-implemented methods described herein.

One aspect of this disclosure relates to a non-transitory computer-readable storage medium storing at least one software code portion, the software code portion, when executed or processed by a computer, is configured to perform any of the computer-implemented methods described herein.

One aspect of this disclosure relates to a data carrier signal carrying any of the computer programs described herein.

Elements and aspects discussed for or in relation with a particular embodiment may be suitably combined with elements and aspects of other embodiments, unless explicitly stated otherwise. Embodiments of the present invention will be further illustrated with reference to the attached drawings, which schematically will show embodiments according to the invention. It will be understood that the present invention is not in any way restricted to these specific embodiments.

## BRIEF DESCRIPTION OF THE DRAWINGS

Aspects of the invention will be explained in greater detail by reference to exemplary embodiments shown in the drawings, in which:

FIG. 1 illustrates a patient support element comprising the system for imaging a human breast according to an embodiment;

FIG. 2A illustrates the bottom side of the patient support element of figure 1;

FIG. 2B illustrates the interior of the patient support element of figure 1;

FIG. 3A shows a bottom perspective view of an antenna support element according to an embodiment;

FIG. 3B shows a top perspective view of the antenna support element of figure 3A;

FIG. 4A shows a bottom perspective view of the system according to an embodiment;

FIG. 4B shows a top perspective view of the system of figure 5A;

FIG. 5 shows various views of the embodiment of figure 4A;

FIG. 6A is a bottom perspective view of a second antenna system according to an embodiment;

FIG. 6B is a bottom perspective view of the second antenna system shown in figure 6A;

FIG. 7 shows various views of the second antenna system of figure 6A;

FIG. 8A is a bottom perspective view of the first and second antenna system according to an embodiment;

FIG. 8B is a top perspective view of the first and second antenna system of figure 8A;

FIG. 9 shows various views of the configuration of figure 8A;

FIG. 10 schematically shows a circuit for controlling the system according to an embodiment;

FIG. 11 schematically illustrates a data processing system according to an embodiment.

## DETAILED DESCRIPTION OF THE DRAWINGS

In the figures, identical reference numbers indicate identical or similar elements.

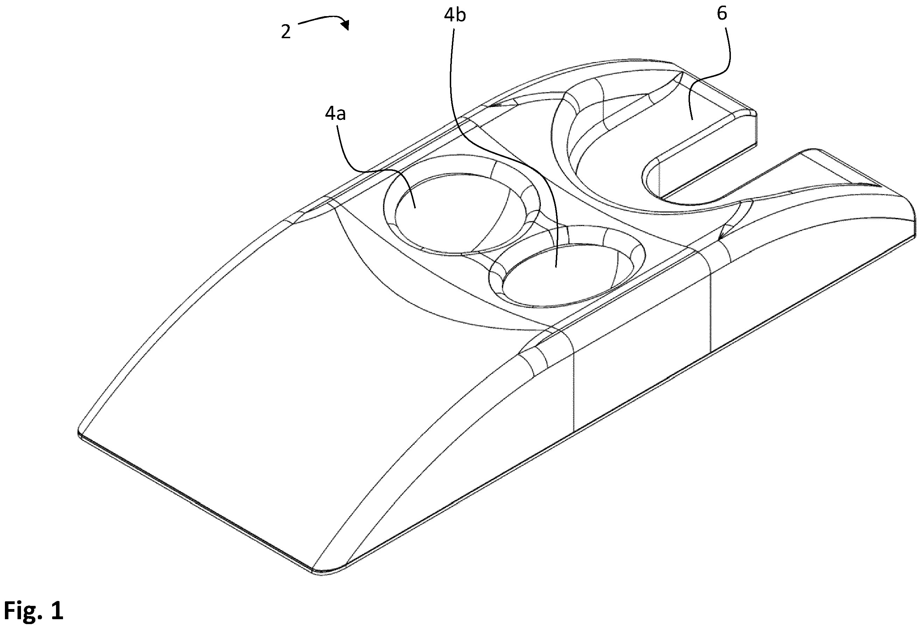

Figure 1 illustrates a patient support element 2 for supporting a patient who lies in the inner bore of an MRI scanner. The support element 2 comprises two volumes 4a and 4b for accommodating the respective breasts of the (female) patient. A strong magnetic field, typically referred to as the $B_0$ field, is generated in the scanner bore of the MRI scanner to align the magnetic moments of nuclei in the patient parallel or anti-parallel to the direction of the $B_0$ field.

The support element 2 comprises a system as disclosed herein for imaging a human breast using MRI, which, as referred to herein, also includes magnetic resonance spectroscopy (MRS) and magnetic resonance spectroscopic imaging (MRSI). The second antenna system and first antenna system emit radio frequency pulses that, if they have the correct frequency, can excite nuclei meaning that they cause the magnetic moments of nuclei to change from parallel to anti-parallel alignment. After some time, the magnetic moments of the excited nuclei will revert to the parallel alignment and when this happens the nuclei emit so-called nuclear magnetic resonance (NMR) relaxation signals, which appear as magnetic flux that can be picked up be the second antenna system and first antenna system.

Which frequency is the appropriate frequency for excitation depends on the type of nuclei that are to be excited and on the strength of the $B_0$ field, and is given by $\omega_0 = \gamma B_0$, wherein $\omega_0$ is the Larmor frequency, $\gamma$ is the gyromagnetic ratio associated with the type of nuclei that is to be excited. Nuclei will only be excited if they receive a radio frequency pulse having a frequency equal to the Larmor frequency. Hence, by applying a gradient to the $B_0$ field, only nuclei in a specific area, also referred to as voxel, in the human breast will be excited by a radio frequency pulse having some fixed frequency because only in this specific area will the frequency of the radio frequency pulse be equal to the Larmor frequency. This principle allows to determine the position of the nuclei that emitted the NMR relaxation signals.

The radio frequency pulses that are applied to the human breast preferably originate close to the human breast for efficient excitation. Also, the antennas for receiving the NMR relaxation signals are also preferably positioned closely to the human breast so that even low-power NMR relaxation signals can be detected.

Detect different types of nuclei in the human breast in one scan session is beneficial, because it allows to obtain a more complete view of the substances in the human breast and therefore of the anatomy of the human breast without having to change coils, which would involve moving the patient out of the MRI scanner again and change the settings of the MRI scanner.

In particular, detection of 31P can be used for assessing whether patients respond to cancer treatment as for example described in {Krikken et al. Early detection of changes in phospholipid metabolism during neoadjuvant chemotherapy in breast cancer patients using phosphorus magnetic resonance spectroscopy at 7T; March 2019NMR in Biomedicine 32(433):e4086 DOI:10.1002/nbm.4086}.

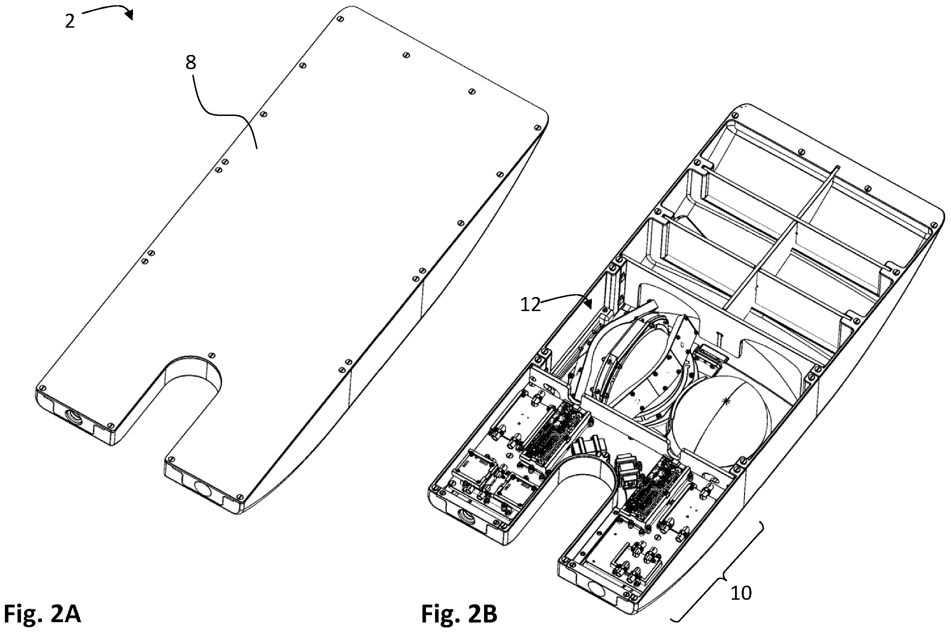

Figure 2A illustrates the bottom side of the patient support 2 having a bottom plate 8. In figure 2B, bottom plate 2B is removed to show the interior of the patient support 2. The patient support 2 comprises a system 12 for imaging a human breast using MRI according to an embodiment. The system 12 is shown in more details in subsequent figures and comprises a first antenna system and second antenna system, wherein the first antenna system comprises one or more linear antennas and the second antenna system comprises one or more loop antennas.

In the embodiment of figure 2B part 10 of the patent support element 2 comprises a first antenna control system and second antenna control system for controlling the first antenna system and, respectively, second antenna system. In particular, the first antenna control system is configured to cause at least one linear antenna, preferably all linear antennas, out of the one or more linear antennas to send excitation signals for exciting nuclei of the first type that are present in the human breast and to process the NMR relaxation signals from the nuclei of the first type as received by the at least one linear antenna. In this sense, the first antenna control system may be understood as being configured for switching the first antenna system between a receive state, in which it can receive and process NRM relaxation signals from the nuclei of the first type, and a transmit state, in which it can send excitation signals for exciting nuclei of the first type.

Likewise, the second antenna control system is configured to cause at least one loop antenna, preferably all loop antennas, out of the one or more loop antennas to send excitation signals for exciting nuclei of the second type that are present in the human breast and to process the NMR relaxation signals from the nuclei of the second type as received by the at least one loop antenna. In this sense, the second antenna control system may be understood as being configured for switching the second antenna system between a receive state, in which it can receive and process NRM relaxation signals from nuclei of the second type, and a transmit state, in which it can send excitation signals for exciting nuclei of the second type.

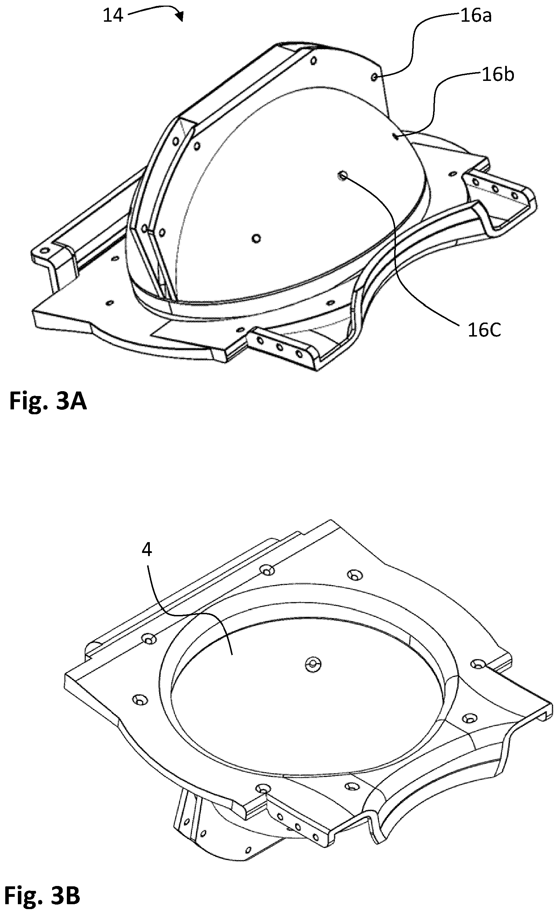

Figure 3A shows a bottom perspective view of an antenna support element 14 that supports the first antenna system and second antenna system, whereas figure 3B shows a top perspective view of this antenna support element. The antenna support element 14 comprises a number of, preferably threaded, holes 16a, 16b, 16c (for clarity purposes, only three are indicated by a reference number), not necessarily through-holes. These holes allow for attaching the one or more loop antennas and one or more linear antennas to the support element 14 herewith fixating the position and orientation of these antennas relative to the antenna support element 14.

As visible in figure 3B, the antenna support element defines a volume 4 that can accommodate the human breast that is to be scanned.

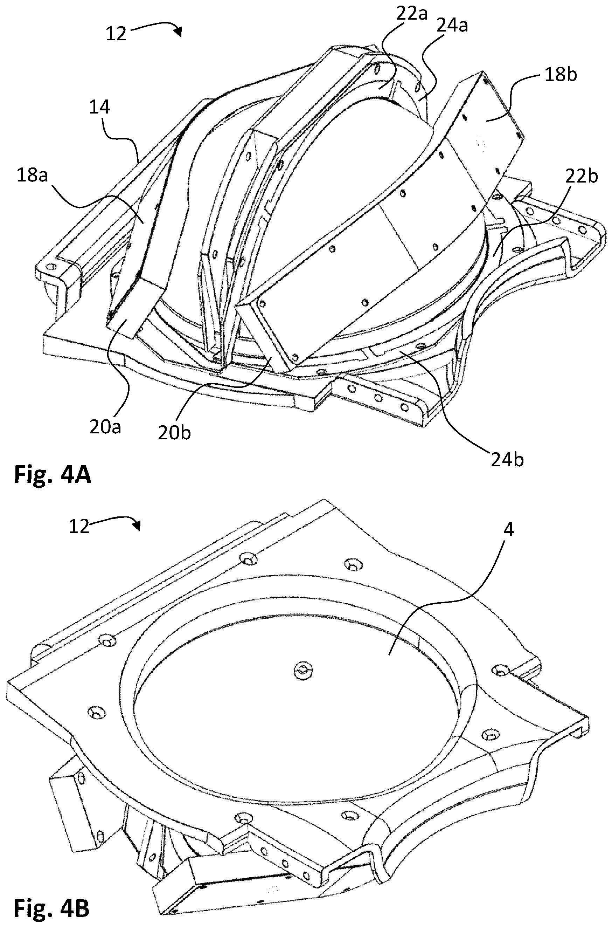

Figure 4A is a bottom perspective view of the system 12 for imaging a human breast using MRI as implemented in the patient support element 2 shown in figure 1. The system 12 comprises a first antenna system that comprises two and only two linear antennas, namely dipole antenna 18a and dipole antenna 18b. Dipole antennas 18a and 18b are tuned the same frequency so that they can both send excitation signals into the human breast for exciting nuclei of a first type, which would typically by 1H nuclei. Additionally, both dipole antennas 18a and 18b can received NMR relaxation signals from the nuclei of the first type.

The dipole antennas 18 and 18b may comprise a meandering conductor. Typically, a dipole antenna has two identical conductors, such as a metal trace, and the driving current is applied between the two identical conductors and/or the output signal is taken from between the two identical conductors. Both identical conductors may be at least partially meandering. In the figures, the conductors of the dipole are not shown.

The dipole antennas 18a and 18b are attached to the antenna support element 14 and bent around at least part of the volume 4 that is configured to accommodate a human breast. In the embodiment of figure 4A, a dielectric spacer 20a, 20b sits between the respective dipole antennas 18a, 18b and the support element 14.

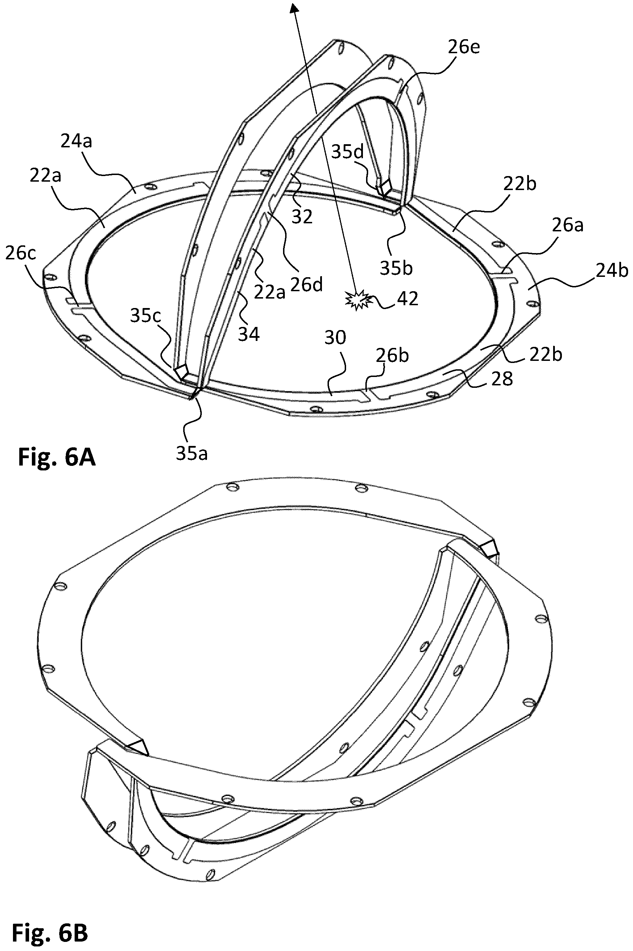

The system as shown in the figures also comprises a second antenna system that comprises two and only two loop antennas 22a and 22b. Loop antennas 22a and 22b are tuned to the same frequency so that they can both send excitation signals into the human breast for exciting nuclei of a second type. In a preferred embodiment, the nuclei of the second type are 31P nuclei. Additionally, both loop antennas 22a and 22b can received NMR relaxation signals from the nuclei of the second type. The loop antennas 22a and 22b are more clearly visible in figures 6A and 6B, from which, for clarity, the antenna support element 14 and dipole antennas 18a and 18b are not shown.

An important advantage of having at least two loop antennas and at least two dipole antennas is that it allows for the second antenna system and, respectively, the first antenna system to send excitation signals in quadrature, which is relatively energy efficient. The dipole antennas of the first antenna system may not be oriented precisely at 90 degrees from each other. Hence, the correct phase shift between the excitation signals as transmitted by one dipole antenna and the excitation signals as transmitted by another dipole antenna may not be 90 degrees either. The same holds for the loop antennas of the second antenna system. The person skilled in the art will know how to determine the correct phase shift between excitation signals as transmitted by two linear antennas, or as transmitted by two loop antennas. Based on the respective orientations of the antennas, can the appropriate phase offset be determined for a specific position at which the excitation signals are to arrive nicely in quadrature. For the systems for imaging a human breast disclosed herein, the phase offset would typically be calculated for a position somewhere near the center of the volume that will accommodate the human breast.

Each antenna of the system, whether it be a linear antenna or loop antenna, is preferably single-tuned in that it does not comprise a tuning circuit with a PIN diode for tuning the antenna, by means of electrical signaling provided to the tuning circuit. Such PIN diodes have a resistance, even when forward biased, which reduces the signal to noise ratio. This is undesired, especially if 31P nuclei are scanned, for example, which emit relatively weak NMR relaxation signals.

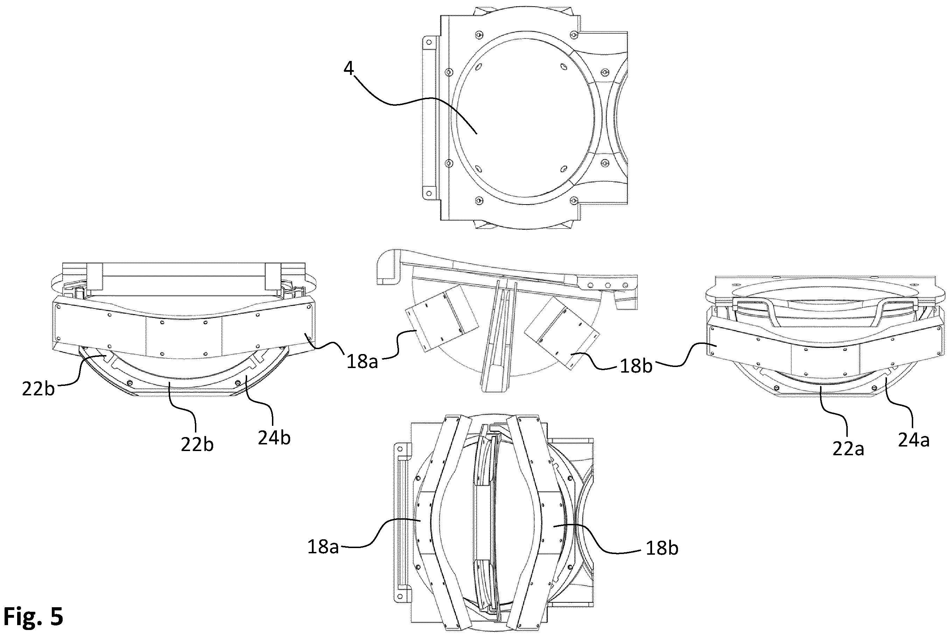

Figure 5 shows the top view (top), front view (middle), bottom view (bottom), left-side view (left), and right-side view (right) of the system 12 as shown in figures 4A and 4B.

Figure 6A is a bottom perspective view of the second antenna system comprising coil 22a and coil 22b, and figure 6B is a top perspective view of this second antenna system. Each of loop antennas 22a and 22b is formed by a conductive trace, which may be a copper trace, provided on respective dielectric coil support elements 24a and 24b. In the depicted embodiment, each trace comprises interruptions 26a, 26b, 26c, 26d, 26e where capacitors can be placed having appropriate capacitance values. As such, the conductive trace with capacitors placed at the interruptions may be understood as a conductor loop. In the depicted embodiment, at least part of which is bent around the volume 4. Also, each conductor loop comprises one or more kinks. In the depicted embodiment, the conductor loop of loop antenna 22a comprises a kink 35a and a kink 35b, while the conductor loop of loop antenna 22b comprises a kink 35c and a kink 35d. These kinks in the conductor loops create sufficient space for the linear antennas (not shown in figure 6A).

In the embodiment as shown in the figures, the conductor loop of loop antenna 22a and the conductor loop of loop antenna 22b partially overlap in that a flux (schematically indicated by the arrow) originating from a nucleus 42 may be detected both by loop antenna 22a and by loop antenna 22b.

Further, each coil 22a, 22b may be connected to a signal cable at one of these interruptions 26a, 26b, 26c, 26d, 26e, so that signals can be provided to and received from the loop antenna. To illustrate, loop antenna 22b may be connected to a coax cable at interruption 26b, wherein the conducting shield of the coax cable is connected to conductor part 28 of loop antenna 22b and the inner conductor of the coax cable is connected to the conductor part 30 o loop antenna 22b. Likewise, loop antenna 22a may be connected to a coax cable at interruption 26d, wherein the conducting shield of the coax cable is connected to conductor part 32 of loop antenna 22a and the inner conductor of the coax cable is connected to the conductor part 34 of loop antenna 22a.

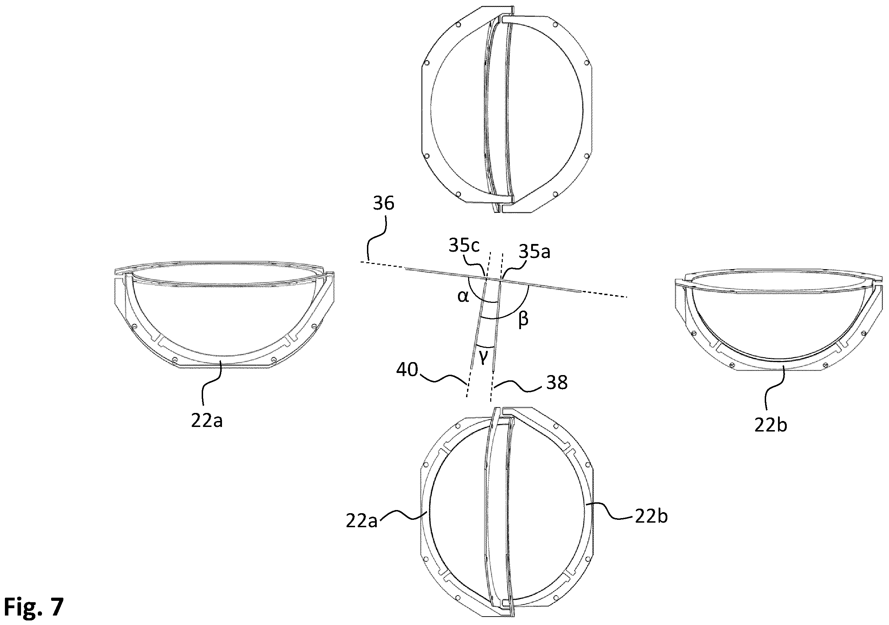

Figure 7 shows a front view (middle), top view (top), bottom view (bottom), left-side view (left), and right-side view (right) of the second antenna system depicted in figures 6A and 6B.

As becomes clear from the front view (middle), the conductor loop of loop antenna 22a comprises a first part that lies in plane 36 and a second part that lies in plane 38. The planes 36 and 38, and therefore the first part and second part of the conductor loop of loop antenna 22a, make an angle $\alpha$ with each other. Further, the conductor loop of loop antenna 22b comprises a first part that lies in plane 36 and a second part that lies in plane 40. The planes 36 and 40, and therefore the first part and second part of the conductor loop of loop antenna 22b make an angle $\beta$ with each other. Further, planes 38 and 40 make an angle $\gamma$ with each other. Each conductor loop is kinked, see kinks 35a and 35c, there where plane 36 meets with planes 38 and 40.

Angles $\alpha$ and $\beta$ may be equal to each other but this is not strictly required. Each of angles $\alpha$ and $\beta$ is for example between 80 and 110 degrees, preferably between 90 and 110 degrees. Angle $\gamma$ may be less than 20 degrees, preferably less than 10 degrees. In the depicted embodiment, angle $\gamma$ is less than 5 degrees.

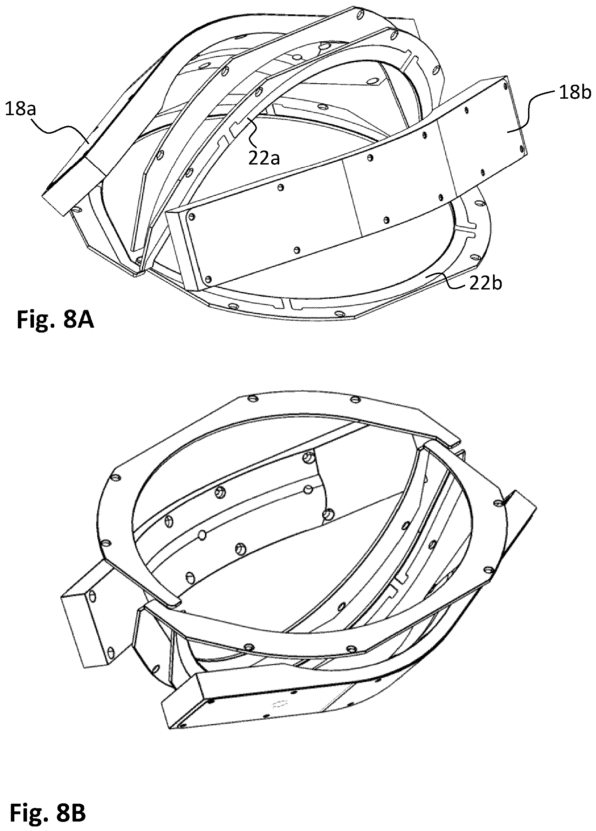

Figure 8A is a bottom perspective view of the two loop antennas 22a and 22b of the second antenna system and dipole antennas 18, 18b of first antenna system in isolation. Figure 8B is a top perspective view of the configuration as shown in figure 8A.

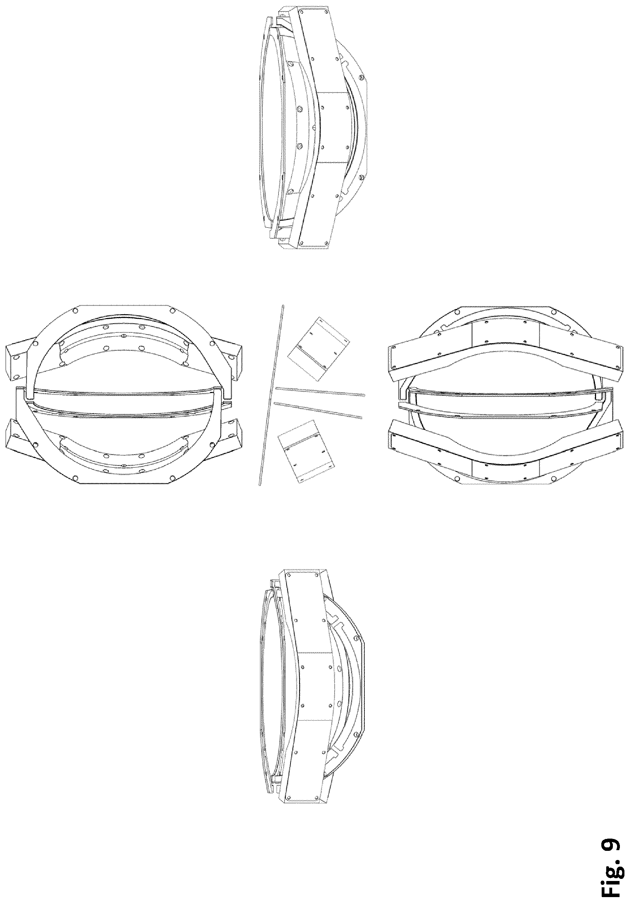

Figure 9 shows front view (middle), top view (top), bottom view (bottom), left-side view (left), and right-side view (right) of the configuration shown in figures 8A and 8B.

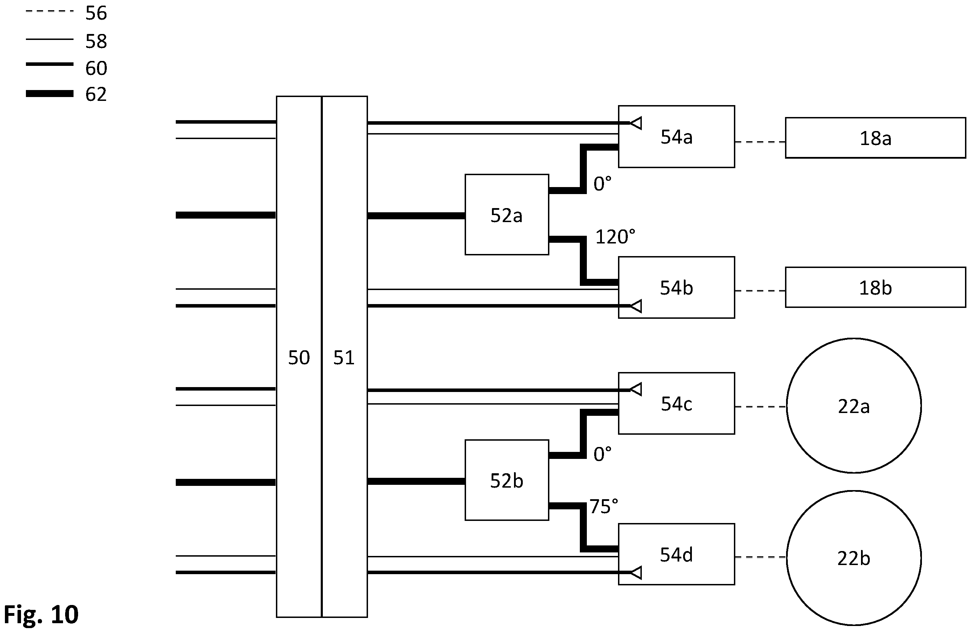

Figure 10 shows a circuit for controlling the system according to an embodiment. Element 51 indicates a plug, also referred to as the coil connection panel 51, that can be inserted into a socket 50 of the MRI scanner in question.

Further indicated is a first linear antenna 18a, a second linear antenna 18b, a first loop antenna 22a and a second loop antenna 22b. Each antenna 18a, 18b, 22a, 22b is connected to a switch element 54a, 54b, 54c, 54d. Each switch element 54 is configured to switch between a transmit state and a receiver state. In the transmit state, it forwards high-power RF signals to one of the antennas. In the receiver state, it forwards signals as detected by one of the antennas to the plug 51.

Dashed lines 56 indicate lines that are configured to transmit high-power RF signals from the switch to an antenna and to transmit signals as received by the antenna to the switch element 54.

Solid lines 58 indicate control lines that would typically conduct DC signals to the switch elements 54 in order to control whether the switch element 54 is in the receiver state or transmit state.

Solid lines 60 indicate reception lines that are configured to conduct signals as received by an antenna, via the plug 51 and socket 50 to a further signal processing system of the MRI scanner.

Solid lines 62 indicate power lines that are configured to conduct high-power RF signals from one or more amplifiers (not shown) via power splitters 52a and 52b to the switch elements 54 (which forwards these signal via lines 56 to the antennas). Lines 56, 60 and 62 are typically embodied as coax cables.

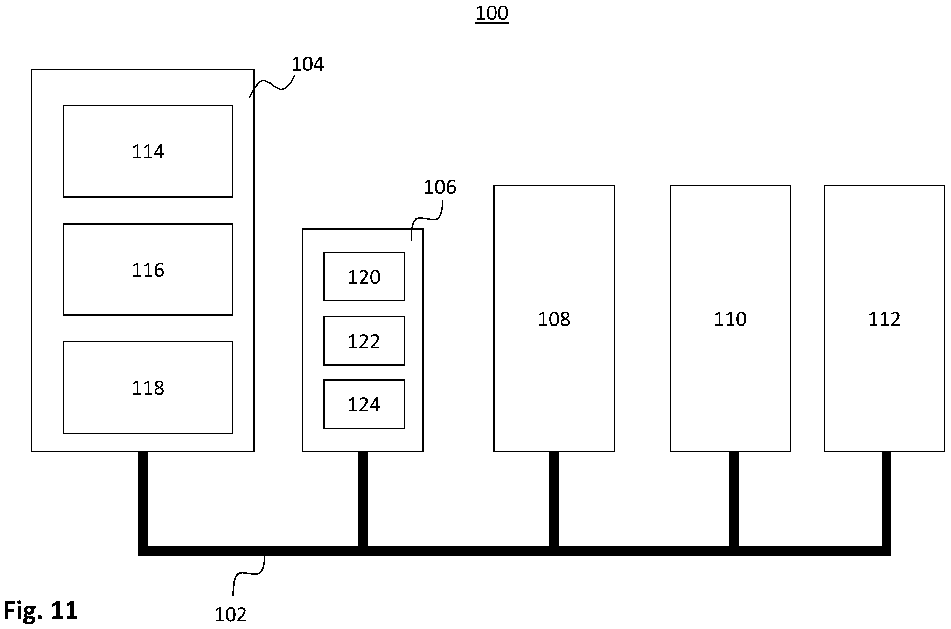

Figure 11 schematically illustrates a data processing system 100, also referred to as a computer, according to an embodiment. The data processing system 100 may for example represent the first antenna control system and/or the second antenna control system referred to herein.

In data processing system 100, a system bus 102 connects the different components of the data processing system 100. In particular, the system bus 102 depicted in figure 11 connects the Central Processing Unit (CPU) 104, memory elements 106, input devices 108, output devices 110 and communication devices 112 with each other so that they can exchange information. The system bus 102 may be understood to serve both as data bus, address bus and control bus known in the art.

The CPU 104 is configured to perform steps as per the instructions comprised in a computer program. To illustrate, based on such instructions, the CPU may perform any of the computer-implemented methods described herein. Typically, the CPU 104 is embodied as a microprocessor, which can be implemented on a single metal-oxide-semiconductor integrated circuit chip. The CPU 104 comprises a control unit 114, an arithmetic logical unit (ALU) 116 and a plurality of registers 118.

The control unit 114 is configured to retrieve instructions from a main memory 120. Typically, the control unit 114 comprises a binary decoder to convert the retrieved instructions into timing and control signals that direct the operation of for example the ALU 116. ALU 116 is configured to perform logical operations, such as additions, subtraction, multiplication, division and Boolean operations, that are required for carrying out the instructions. The registers 118 are small memory elements that can be read and written at relatively high speed. A register may for example store an instruction, a storage address, or any other kind of data. In addition, the CPU may contain hardware caches known in the art (not shown). Preferably the CPU has different levels of caches. These hardware caches may be understood as an intermediate state between the faster registers 119 and the slower main memory 120.

Memory elements 106 comprise a main memory 120. The main memory 120, also referred to as primary storage in the art, has stored data that is directly accessible to the CPU 104. The CPU 104 may continuously read instructions, i.e. read computer programs, stored in the main memory 120 and execute these instructions. The main memory 120 is typically a random access memory (RAM).

Memory elements 106 further comprise so-called secondary storage 122, which may be embodied as one or more hard disk drives and/or as one or more solid state drives. Typically, these secondary storage is non-volatile. Further, the memory elements may comprise other storage devices 124, such as removable storage devices, e.g. CD, DVD, USB flash drives, floppy disks, et cetera.

Input devices 108 may be understood as devices that are used to provide information to the computer 100, in particular to the CPU 104. Non-limiting examples of input devices are a keyboard, a microphone, a joystick, a mouse, a touch sensitive screen, et cetera. Output devices 110 may be understood as devices that output information out of the computer and/or as devices that are controlled by the computer. Non-limiting examples of output devices 110 are a display, a printer, a headphones, loudspeaker, a motor-generator referred to herein, any of the actuators referred to herein, et cetera.

Communication devices 112 may be understood as devices that allow the computer system to communicate with other computers, such as with a server computer, client computer, or any other type of remote device. Non-limiting examples of communication devices 112 include modems, cable modems, ethernet cards, Bluetooth modules, et cetera.

**Claims**

1. A system for imaging a human breast using magnetic resonance imaging, MRI, the system comprising

   a first antenna system comprising one or more linear antennas, wherein each linear antenna out of the one or more linear antennas is tuned to a first frequency and is configured to send excitation signals having the first frequency into the human breast for exciting nuclei of a first type that are present in the human breast and/or is configured to receive nuclear magnetic resonance, NMR, relaxation signals from the nuclei of the first type in the human breast, and
   a second antenna system comprising one or more loop antennas, wherein each loop antenna is tuned to a second frequency that is different from the first frequency, and is configured to send excitation signals having the second frequency into the human breast for exciting nuclei of a second type that are present in the human breast, the second type being different from the first type, and/or is configured to receive NMR relaxation signals from the nuclei of the second type in the human breast.

**2.** The system according to any of the preceding claims, wherein the one or more linear antennas comprise at least two linear antennas and the one or more loop antennas comprise at least two loop antennas.

**3.** The system according to claim 1 or 2, wherein

each linear antenna out of the one or more linear antennas is single-tuned, and wherein
each loop antenna out of the one or more loop antennas is single-tuned.

**4.** The system according to any of the preceding claims, preferably according to at least claim 3, wherein the system does not comprise a tuning circuit with a PIN diode for tuning, by means of electrical signaling provided to the tuning circuit, any loop antenna out of the one or more loop antennas.

**5.** The system according to any of the preceding claims, wherein

the first antenna system comprises a first antenna control system that is configured to cause at least one linear antenna out of the one or more linear antennas to send excitation signals for exciting nuclei of the first type that are present in the human breast and to process the NMR relaxation signals from the nuclei of the first type as received by the at least one linear antenna, and wherein
the second antenna system comprises a second antenna control system that is configured to cause at least one loop antenna out of the one or more loop antennas to send excitation signals for exciting nuclei of the second type that are present in the human breast and to process the NMR relaxation signals from the nuclei of the second type as received by the at least one loop antenna.

**6.** The system according to any of the preceding claims, wherein the nuclei of the first type are 1H nuclei.

**7.** The system according to any of the preceding claims, wherein the nuclei of the second type are 31P nuclei.

**8.** The system according to any of the preceding claims, wherein

the system comprises a volume for accommodating the human breast, wherein
the one or more linear antennas and the one or more loop antennas are positioned around the volume.

**9.** The system according to claim 8, wherein each linear antenna out of the one or more linear antennas is bent around at least part the volume.

**10.** The system according to any of the preceding claims, wherein each loop antenna comprises a conductor loop that comprises a first part and a second part, which first part and second part lie in respective different planes that make an angle with each other.

**11.** The system according to any of the preceding claims, wherein each loop antenna comprises a or the conductor loop that is kinked at a plurality of positions along the conductor loop.

**12.** The system according to any of the preceding claims, wherein

the one or more loop antennas comprises a or the first loop antenna and a or the second loop antenna, wherein
the first loop antenna comprises a first conductor loop and the second loop antenna comprises the second conductor loop, wherein
the firs conductor loop and second conductor loop at least partially overlap each other.

**13.** The system according to any of the preceding claims, wherein each linear antenna out of the one or more linear antennas comprises a meandering conductor.

**14.** A method for imaging a human breast using magnetic resonance imaging, MRI, with the system according to any of the preceding claims, the method comprising

during a first time period, the first antenna system sending excitation signals having the first frequency to the human breast herewith exciting nuclei of the first type that are present in the human breast, and
during a second time period after the first time period, the first antenna system receiving NMR relaxation signals from the nuclei of the first type, and
during a third time period, the second antenna system sending excitation signals having the second frequency to the human breast herewith exciting nuclei of the second type that are present in the human breast, and
during a fourth time period after the third time period, the second antenna system receiving NMR relaxation signals from the nuclei of the second type.

**15.** The method according to claim 14, wherein

during the first and second time period, each loop antenna of the one or more loop antennas remains tuned to the second frequency, and during the third and fourth time period, each linear antenna of the one or more linear antennas remains tuned to the first frequency.

**Fig. 1**

**Fig. 2A**

**Fig. 2B**

EP 4 737 932 A1

14 ⟶

16a

16b

16C

**Fig. 3A**

4

**Fig. 3B**

**Fig. 4A**

**Fig. 4B**

**Fig. 5**

Fig. 6A

Fig. 6B

**Fig. 7**

Fig. 8A

Fig. 8B

**Fig. 9**

Fig. 10

**Fig. 11**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/300946 A1 (ZHENG HAIRONG [CN] ET AL) 24 September 2020 (2020-09-24) * paragraphs [0016] - [0018], [0022], [0023], [0052], [0053]; figures 1,2,4,5 * | 1-7, 10-15 | INV. G01R33/36 |
| X | Wavetronica: "Esmé Galesloot of WaveTronica BV presents the MIRACLE project at FMIR2024 organized by KALCIO", , 6 June 2024 (2024-06-06), XP093260630, Retrieved from the Internet: URL:https://www.youtube.com/watch?v=XwA7DI HI7eg&t=617s * the whole document * | 1,2,5-9, 14 | |
| A | US 8 217 653 B2 (VAUGHAN J THOMAS [US]; UNIV MINNESOTA [US]) 10 July 2012 (2012-07-10) * the whole document * | 1-15 | |
| A | DU FENG ET AL: "Numerical Simulation and Evaluation of a Four-Channel-by-Four-Channel Double-Nuclear RF Coil for 1H MRI and 31P MRSI at 7 T", IEEE TRANSACTIONS ON MAGNETICS, IEEE, USA, vol. 54, no. 11, 1 November 2018 (2018-11-01), pages 1-5, XP011692317, ISSN: 0018-9464, DOI: 10.1109/TMAG.2018.2856529 [retrieved on 2018-10-17] | 1-15 | **TECHNICAL FIELDS SEARCHED (IPC)** G01R |

The present search report has been drawn up for all claims

| Place of search | Date of completion of the search | Examiner |
|---|---|---|
| Munich | 25 March 2025 | Ó Donnabháin, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EP 4 737 932 A1

**ANNEX TO THE EUROPEAN SEARCH REPORT
ON EUROPEAN PATENT APPLICATION NO.**  EP 24 21 0141

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2025

| Patent document cited in search report | Publication date | Patent family member(s) | Publication date |
|---|---|---|---|
| US 2020300946 A1 | 24-09-2020 | CN 108680882 A | 19-10-2018 |
| | | EP 3614159 A1 | 26-02-2020 |
| | | US 2020300946 A1 | 24-09-2020 |
| | | WO 2020000818 A1 | 02-01-2020 |
| US 8217653 B2 | 10-07-2012 | US 2009237077 A1 | 24-09-2009 |
| | | WO 2009105701 A1 | 27-08-2009 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090118611 A1

**Non-patent literature cited in the description**

- **KRIKKEN et al.** Early detection of changes in phospholipid metabolism during neoadjuvant chemotherapy in breast cancer patients using phosphorus magnetic resonance spectroscopy at 7T;. *NMR in Biomedicine*, March 2019, vol. 32 (433), e4086